# EUROPEAN PATENT APPLICATION

(11) **EP 2 276 055 A1**
(43) Date of publication of application: **19.01.2011**
(21) Application number: 09165337.8
(22) Date of filing: 13.07.2009
(51) Int. Cl.: H01J 37/34

(54) **Target backing tube, cylindrical target, and cylindrical target assembly**

(71) Applicant: Applied Materials, Inc., Santa Clara, CA 95054 (US)
(72) Inventor: Schnappenberger, Frank, 55218, Ingelheim (DE); Weber, Roland, 63755, Alzenau (DE); Krempel-Hesse, Joerg, 63694, Limeshain (DE); Hellmich, Anke, 63796, Kahl (DE)
(74) Representative: Zimmermann & Partner

(57) **Abstract**

A target backing tube is described. The target backing tube is for a rotatable target and includes a tube adapted for one or more non-bonded target cylinders to be disposed around the tube, the tube having an exterior surface adapted to face the at least one target cylinder and at least three or more protrusion receiving positions; and protrusions mounted on the exterior surface of the tube at each of the protrusion receiving positions for centering the target cylinders.

## Description

The present disclosure relates to a target backing tube for a rotatable target. According a further embodiment, the present invention relates to a target backing tube. The present disclosure relates to a cylindrical target assembly. More specifically, it relates to sputter apparatuses having a rotatable target and methods of operating thereof. In particular, the present disclosure relates to a cylindrical target assembly comprising a target backing tube having an exterior surface and at least one target cylinder disposed around the target backing tube.

### BACKGROUND

In many applications, it is necessary to deposit thin layers on a substrate. The term "substrate" as used herein shall embrace both inflexible substrates, e.g. a wafer or a glass plate, and flexible substrates such as webs and foils. Known techniques for depositing layers are in particular evaporating, sputtering and chemical vapor deposition.

Representative examples include (but are not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

In an evaporation process, the material to be deposited is heated so that it evaporates and condenses on the substrate. Sputtering is a vacuum coating process used to deposit thin films of various materials onto the surface of a substrate. For example, sputtering can be used to deposit a metal layer such as a thin layer of aluminum or ceramics. During the sputtering process, the coating material is transported from a target consisting to the substrate to be coated by bombarding the surface of the target with ions of an inert gas that are accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of exposing the substrate to the sputtering process.

Typically, sputtering systems are used to coat substrates, for example window paints, semiconductor devices, displays, and the like. Typically plasma is formed in a vacuum chamber, in which he sputtering target is disposed. For example, rotating sputtering targets may be used. Typically, the rotating sputtering targets have a cylindrical form and rotate about their longitudinal axis. The sputtering targets are disposed on a backing tube in which magnetrons may be arranged. The magnetrons may be driven by a direct current or an alternating current. The magnetrons are used to create the plasma in the vacuum chamber.

In some embodiments, the targets are not bonded to the target backing tube. Typically, a plurality of targets is disposed on a backing tube. The magnetrons in the target backing tube are typically cooled. On the other hand, in the vacuum chamber, very high temperatures of the target are created during the physical vapor deposition, in particular as a function of the applied power and the reason that at least the target can more or less only cool down because of radiation in the vacuum. Thus, the targets may expand or retract due to thermal expansion. For example, the cylindrical target elements abut against each other such that a relative movement of a first target with respect to a second target may provoke particles to fall off the cylindrical targets. This may contaminate the substrate being coated.

### SUMMARY

In light of the above, a target backing tube for a rotatable target according to independent claim 1 and a target cylinder for a rotatable cylindrical target assembly of a sputtering system according to independent claim 12 are provided.

According to one embodiment, a target backing tube for a rotatable target is provided including a tube adapted for one or more non-bonded target cylinders to be disposed around the tube, the tube having an exterior surface adapted to face the at least one target cylinder and at least three or more protrusion receiving positions; and protrusions mounted on the exterior surface of the tube at each of the protrusion receiving positions for centering the target cylinders.

In an embodiment, which may be combined with other embodiments disclosed herein, at least three protrusions per target cylinder are mounted on the exterior surface for supporting and centering the target cylinders when the target cylinders are arranged for a sputtering operation on the target backing tube.

In a further embodiment, the tube is adapted for at least two target cylinder to be disposed around the tube adjacent to each other, wherein each target cylinder has a first end and a second end in direction of the cylinder axis opposite to the first end, wherein the first end of a first target cylinder is disposed adjacent to the second end of a second target cylinder, wherein a contact region is defined between the first end of the first target cylinder and the second end of the second target cylinder, respectively, when the target cylinders are arranged for a sputtering operation on the tube; wherein the at least three protrusion receiving positions are arranged on the exterior surface of the tube at the contact region, such that the protrusion is adapted to support and center the first end of the first target cylinder and the second end of the second target cylinder.

Typically, the contact region is substantially circular.

In a typical embodiment, at least three protrusion receiving positions are arranged with an angular displacement of 120 degrees in circumferential direction of the tube, in particular at the contact region.

In an exemplary embodiment, which may be combined with other embodiments disclosed herein, the at least one protrusion are selected from the group consisting of: a nose; a resilient member, in particular a spring; a circular spring that is arranged substantially circumferential, a solid center element with a support surface and combinations thereof.

Typically, the tube comprises a recess at least at one, in particular at each protrusion receiving position for a particular target cylinder when arranged for a sputtering operation on the tube, wherein the at least one protrusion is arranged in the recess.

In an embodiment, the recess is a substantial circular groove.

In a further embodiment, which may be combined with other embodiments disclosed herein, at least one protrusion, in particular each protrusion for a particular target cylinder when arranged for a sputtering operation on the tube, has at least one support surface, wherein the at least one first support surfaces is substantial parallel to the exterior surface of the tube.

In a typical embodiment, at least one protrusion, in particular each protrusion for a particular target cylinder when arranged for a sputtering operation on the tube, has two support surfaces that are oblique to the exterior surface of the tube, wherein the two support surfaces have a common edge, wherein the common edge is disposed substantially parallel to exterior surface of the tube in circumferential direction, wherein in particular the common edge forms a segment of a circular arc.

Typically, the support surfaces have an angle with respect to the exterior surface of the tube of between 1 and 89 degrees, in particular between 1 and 45 degrees. According to a further embodiment, a target cylinder for a rotatable cylindrical target assembly of a sputtering system is provided, wherein the target cylinder has a first end and a second end in direction of the cylinder axis opposite to the first end, and an inner surface adapted to face a target backing tube onto which the target cylinder is adapted to be disposed and exterior surface, wherein at least one support surfaces are disposed in at least one cut-out at the first end and the second end at the inner surface, respectively.

In an embodiment, the target cylinder comprises at least three support surfaces at the first end and the second end respectively, in particular arranged with an angular displacement of 120 degrees.

Typically, the support surfaces are inclined with respect to the inner surface of the target cylinder.

According to another embodiment, a cylindrical target assembly is provided including a target backing tube and at least one first target cylinder and at least one second target cylinder disposed around the target backing tube, wherein each target cylinder has a first end and a second end in direction of the cylinder axis opposite to the first end, wherein the first end of a first target cylinder is disposed adjacent to the second end of a second target cylinder.

Typically, the at least one first target cylinder and/or the at least one second target cylinder is a target cylinder according to one of the embodiments disclosed herein,

In an embodiment, the first end of the first target cylinder and the second end of the second target cylinder comprise a tongue and groove connection system, so that the tongue is arranged at the first end of the first target cylinder and the groove is disposed at the second end of the second target cylinder.

Typically, the first target cylinder and the second target cylinder have an inclined first end surface at their first end and an inclined second end surface at their second end with respect to an interior surface of the respective target cylinders, wherein the first end surface of the first target cylinder and the second end surface of the second target cylinder are substantially parallel.

For example, in an embodiment, which may be combined with other embodiments disclosed herein, the inclination angle of the first and second end surfaces is between 1 and 89 degrees, in particular between 20 and 70 degrees, with respect to the interior surface of the target cylinder.

In an embodiment, the support surface of the target cylinder is substantially parallel to the support surface of the protrusion supporting the target cylinder.

Typically, the cylindrical target assembly according to one embodiment further comprises a stop disposed on the target backing tube, in particular at an end of the target backing tube in direction of the cylinder axis, wherein the stop is adapted to support the adjacent target cylinder in direction of the cylinder axis; and at least one biasing device for pushing the target cylinders in direction of the stop in direction of the cylinder axis.

In an embodiment, the cylinder axis of the target backing tube is arranged substantially vertical; wherein the at least one biasing device is adapted to slide in direction of the cylinder axis of the target backing tube, and is arranged such that the gravity of the biasing device pushes the target cylinders in direction of the stop.

Typically, in an embodiment, which may be combined with other embodiments disclosed herein, the stop is arranged at the lower end of the target backing tube.

In an embodiment, the at least one biasing device comprises at least one resilient member for pushing the target cylinders in direction of the stop.

In a further embodiment, which may be combined with other embodiments disclosed herein, the at least one biasing device is adapted to be fixed to the target backing tube

Further aspects, advantages and features of the present invention are apparent from the dependent claims, the description and the accompanying drawings.

### BRIEF DESCRIPTION OF THE DRAWINGS

A full and enabling disclosure including the best mode thereof, to one of ordinary skill in the art, is set forth more particularly in the remainder of the specification, including reference to the accompanying figures wherein:
Fig. 1 shows a cross-section of an embodiment of a sputtering system;
Fig. 2 shows a perspective view of an embodiment of a cylindrical target assembly;
Fig. 3a shows a longitudinal cross-section of an embodiment of a cylindrical target assembly;
Fig. 3b shows a longitudinal cross-section of an embodiment of a cylindrical target assembly;
Fig. 3c shows a cross-section of an embodiment of a cylindrical target assembly;
Fig. 4 shows a cross-section of a further embodiment of a cylindrical target assembly;
Fig. 5 shows a cross-section of another embodiment of a cylindrical target assembly;
Fig. 6 shows a longitudinal cross-section of a further embodiment of a cylindrical target assembly;
Fig. 7 shows a longitudinal cross-section of another embodiment of a cylindrical target assembly;
Fig. 8 shows a longitudinal cross-section of a further embodiment of a cylindrical target assembly;
Fig.9 shows a longitudinal cross-section of another embodiment of a cylindrical target assembly;
Fig. 10 shows a longitudinal cross-section of a further embodiment of a cylindrical target assembly;
Fig. 11 shows a longitudinal cross-section of another embodiment of a cylindrical target assembly;
Fig. 12 shows a longitudinal cross-section of an embodiment of a cylindrical target assembly having a vertical rotation axis;

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

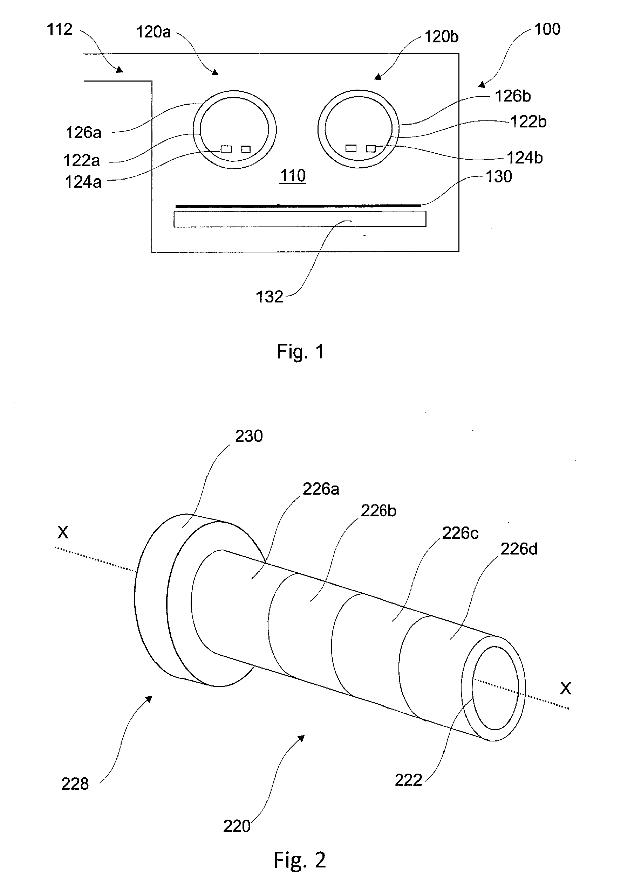

Referring to the drawings, where like or similar elements are designated with identical reference numbers throughout the different figures, Fig. 1 shows a schematic cross-section of a sputtering system 100 having a vacuum chamber 110. The vacuum chamber has an inlet port 112, which may be used to provide a sputtering gas into the vacuum chamber 110, and an outlet (pumping) port (not shown). In typical embodiment, the sputtering system 100 includes two rotating cylindrical target assemblies 120a, 120b. In another embodiments, which may be combined with other embodiments disclosed herein, the sputtering system may include one, three, four or more cylindrical target assemblies.. In a typical embodiment, which may be combined with other embodiments disclosed herein, the rotating cylindrical target assemblies 120a, 120b are driven by a drive assembly not shown in Fig. 1. The rotating cylindrical target assemblies 120a, 120b each include a backing tube 122a, 122b in which magnets 124a, 124b are disposed. Further, cylindrical target elements 126a, 126b are disposed around the backing tube 122a, 122b. In Fig. 1 horizontal rotating cylindrical target assemblies are shown. In some embodiments, which may be combined with other embodiments disclosed herein, vertical cylindrical target assemblies may be used.

Further, in the vacuum chamber 110, a substrate 130 is disposed below the cylindrical target assemblies 120a, 120b. The substrate 130 may be arranged, in a typical embodiment, which may be combined with other embodiments disclosed herein, on a substrate support 132. In operation, a plasma is formed inside the vacuum chamber 110 between the cylindrical target assembly and the substrate by exciting a sputtering gas, for example argon. In further embodiments, the vacuum chamber may include substrate drive systems, for driving a substrate to be coated 130 in or out of the vacuum chamber 110. For that reason, the vacuum chamber may include a vacuum lock chamber disposed at a wall of the vacuum chamber 110. Fig. 2 shows a rotary cylindrical target assembly 220 in a perspective view. Typically, the cylindrical target assembly has a cylinder axis X which is also a rotating axis of the cylindrical target assembly. The rotating cylindrical target assembly 220 includes a backing tube 222 and a one or more, for example 5 or more of target elements 226a, 226b, 226c, 226d. In a typical embodiment, which may be combined with other embodiments disclosed herein, the target elements 226a, 226b, 226c, 226d are arranged adjacent to each other on the backing tube 222. The rotary cylindrical target assembly 220 has a first end 228 and a second end (the second end is not shown in Fig. 2), in direction of the cylinder axis or rotation axis X. At the first end 228 a stop 230 is provided. Typically, a target may be also denominated as a tile.

A plurality of target elements 226a, 226b, 226c, 226d are mounted on a backing tube that are, according to embodiments described herein, not bonded to the backing tube 222 such that the target elements may move during a rotation about the rotation axis of the rotating cylindrical target assembly. Such a movement may provoke the generation of particles or flakes that may contaminate the substrate to be processed, for example the substrate 130 in Fig. 1. Thus, in an embodiment, which may be combined with another embodiment disclosed herein, the target elements may be mounted to the backing tube, such that a thermal expansion is allowed, but the target elements do not move with respect to each other. Typically, the target elements or target segments are prevented from moving with respect to each other during operation of the sputtering system. Further, in an embodiment, which may be combined with other embodiments disclosed herein, the target elements may be designed to allow an easy replacement of target segments or elements on the backing tube.

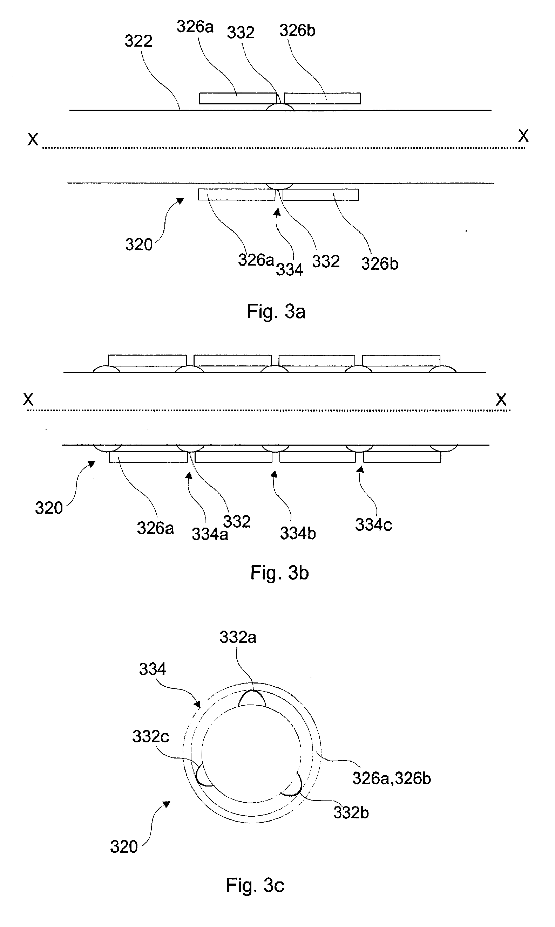

Fig. 3a shows a longitudinal cross-section of an embodiment of a sputtering system, which may be combined with another embodiment, comprising a rotating cylindrical target assembly 320. The rotating cylindrical target assembly includes a backing tube 322 having an exterior surface directed to the target elements and at least two target elements 326a, 326b disposed around the target backing tube. Further, in an embodiment, which may be combined with other embodiments disclosed herein, one or more contact springs 332 are fixed to the backing tube 322 at a circular contact region 334. The circular contact region 334 is defined, in a typical embodiment, which may be combined with other embodiments disclosed herein, as a region, where a first target element abuts a second target element, when the cylindrical target assembly 320 is ready for operation in the vacuum chamber. Typically, the target elements have a predetermined form, in particular a predetermined length along the axis of their cylindrical envelope. The spring force, in a typical embodiment, which may be combined with other embodiments herein, of the contact spring is directed in radial direction. For example the spring may have a contact surface for supporting the target elements. The contact surface may have a surface which has substantially the same dimensions in direction of the cylinder axis and in circumferential direction. Thus, a substantial punctual contact is provided between the target element and the backing tube.

Fig. 3b shows a longitudinal cross-section of the cylindrical target assembly 320, wherein plurality of target elements are mounted on the backing tube 322 ready for operation in a physical vapor deposition chamber, for example the vacuum chamber 110 shown in Fig. 1. As it can be seen from Fig. 3b, in an embodiment, which may be combined with other embodiments disclosed herein, ends in the direction of the rotating or cylinder axis X of a neighboring pair of target elements are abutting each other. Thus, a plurality of circular contact regions 334a, 334b, 334c are formed on the backing tube 322. In a typical embodiment, which may be combined with other embodiments disclosed herein, at each circular contact region one or more springs are disposed for fixing and/or centering the respective target elements on the backing tube 322. Further, the contact springs in one circular contact region may have substantially the same spring constant. Thus, the target elements 326a, 326b, 326c, 326d are concentrically arranged around the backing tube 322. Further, a movement due to the rotation of the backing tube is prevented.

Fig. 3c shows a cross section of the cylindrical target assembly 320 at the circular contact region 334. In a typical embodiment, three contact springs 332a, 332b, 332c are arranged on the backing tube with an angular displacement of about 120 degrees. In further embodiments, more, for example four to six contact springs, may be arranged with a regular angular displacement. In another embodiment, which may be combined with other embodiments disclosed herein, the springs may be arranged in a recess within the backing tube. For example each contact spring may be arranged in a separate recess. As a further additional or alternative option, a circular groove may be arranged that receive all contact springs of a specific contact region. Accordingly, contact springs or one contact spring may be used along the entire circumference, in particular at the contact region, or parts thereof. According to yet further embodiments, a plurality of springs may be arranged in a row in a longitudinal (axial) direction of the backing tube. For example three rows of contact springs may be arranged with a regular angular displacement of about 120 degrees. In light of he above, for example, each target cylinder, when the cylindrical target assembly is ready for operation, is supported at least two axial locations in direction of the cylinder axis X of the target cylinders, which are typically the circular contact regions. At each axial location, the target cylinder may be supported, for example, by at least three protrusions, for example contact springs, having an angular displacement, typically 120 degrees for three contact springs.

In a typical embodiment, which may be combined with other embodiments disclosed herein, the contact springs may be leaf springs.

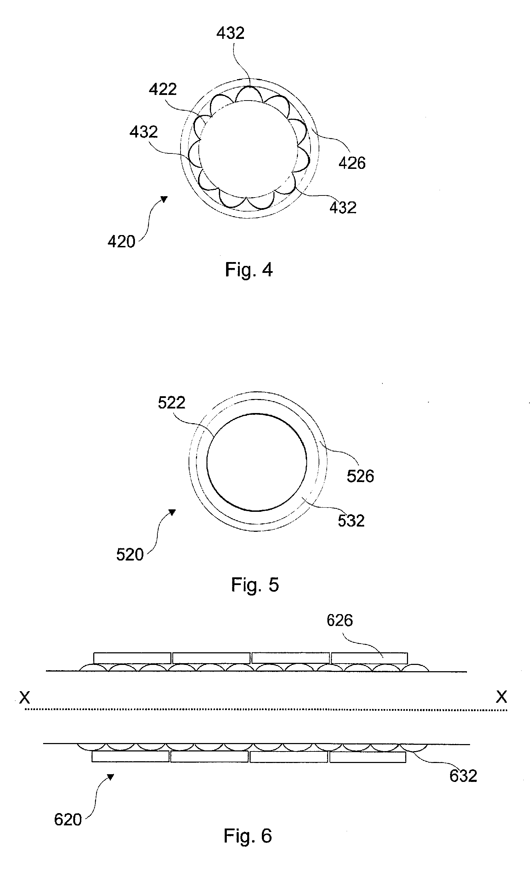

Fig. 4 shows a cross section of an embodiment of a cylindrical target assembly 420, in particular at a circular contact region. The cylindrical target assembly 420 includes a backing tube 422 on which a plurality of contact springs 432a disposed in a contact region around the backing tube 422.

In a further embodiment shown in the cross-section of Fig. 5, which may be combined with other embodiments disclosed herein, a cylindrical target assembly 520 includes a backing tube 522 on which at least one target element 526 is disposed. In a contact region of two adjacent target elements a spring sheet 532 is disposed on the backing tube 520. Typically, the spring sheet 532 includes a layer of a material that has a spring force and flexibility in a radial direction. Thus, the target elements are arranged concentrically around the backing tube 522. In a further embodiment, which may be combined with other embodiments disclosed herein, a circumferential spring pipe or envelope spring is provided around the backing tube 522. In a typical embodiment, the spring material may be a thermo setting alloy, for example Duratherm®600, CuBe Alloys or the like]. For example, the spring sheet may be a helical spring that is wound around the circumference of the backing tube, in particular at a contact region. Thus, the axis of the helical spring corresponds to a circle disposed around the backing tube, wherein the center of the circle is disposed on the cylinder axis or rating axis X of the backing tube. For example, the circular spring includes a plurality of individual spring members. Thereby, according to some embodiments described herein, a target assembly with two or more spring sheets can be provided such that two spring sheets correspond to one target element.

In a further embodiment, shown in the longitudinal cross-section of Fig. 6, the cylindrical target assembly 620 includes a backing tube 622 on which a plurality of contact springs are arranged in a longitudinal direction or parallel to the cylinder axis X of the backing tube. For example, a plurality of contact springs may be arranged in one or more rows parallel to the cylinder axis X of the backing tube. In a further embodiment, a plurality of contact springs may be disposed in a row in a helical manner around the backing tube 622, the axis of the helix is substantial the rotating axis or cylindrical axis. In another embodiment, a longitudinal spring pipe or envelope spring may be used.

In a typical embodiment, which may be combined with other embodiments disclosed herein, the contact springs or the spring sheet, that are for example shown in Figs. 3 to 6 have a low thermal conductivity and a high electrical conductivity. For example, stainless steel springs may be used.

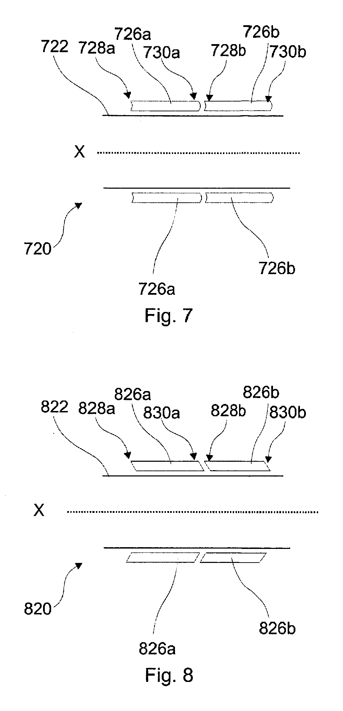

Fig. 7 shows a further embodiment of a portion of a cylindrical target assembly 720 in a longitudinal cross-section. The cylindrical target assembly 720 includes a backing tube 722 and a plurality of target elements 726a, 726b disposed around the backing tube 722. For the sake of clarity, only two target segments are shown. Each target element 726a, 726b has a first end 728a, 728b and a second end 730a, 730b in direction of the cylinder axis X. The first end and the second target element 726a and 726b are arranged on the backing tube, such that the second end 730a of the first target element and the first end 728b of the second target element abut each other. For the sake of clarity, the first and the second target elements 726a, 726b are shown with a gap between them. If the cylindrical target assembly 720 is ready for operation in a vacuum chamber, typically there is no gap between the first and the second target elements 726a, 726b. As it can be seen in Fig, 7, the ends 728a,b, 730a,b of the target elements have a specifically shaped contact area, such that the target elements 726a, 726b are centered with respect to each other. In the embodiment shown in Fig. 7, which may be combined with other embodiments disclosed herein, the first and second ends of the first and second target elements are formed as a tongue and groove system. Thus, the target elements arranged adjacent to each other may not move with respect to each other.

In Fig. 8 a longitudinal cross-section of a further embodiment of a cylindrical target assembly 820 is shown, which may be combined with other embodiments disclosed herein. The cylindrical target assembly 820 includes a backing tube 822 around which a plurality of target elements 728a, 728b are disposed. For the sake of clarity, only two target elements 728a, 728b are shown in Fig. 8 and are shown with a gap between them. In the mounted state, wherein the cylindrical target assembly 820 is ready for operation in a vacuum chamber, there is no gap between a first target element 726a and a second target element 726b. The first target element 726a and a second target element 726b have a first end 828a, 828b and a second end 830a, 830b in direction of the cylinder axis X. The first and second ends 828a, 828b, 830a, 830b are sloped, such that their surface is inclined with respect to the surface of the backing tube 822 in the cross-section. For example, an inclination angle between the surface of a first end 828a, 828b and the surface of the backing tube 822 or the interior surface of the target element may be between 1 and 89 degrees in particular between 1 and 45 degrees. The surface of the first end 828a and the second end 830a, 830b have substantially the same angle with respect to the backing tube when mounted, or their outer or inner surface. Thus, the surfaces of the second end 830a, 830b and the surfaces of the first end 828a, 828b are substantially parallel, in particular when seen in a cross section. Hence, the surfaces of the first end and the surfaces of the second end of the cylindrical target elements are tapered or cone shaped. Thus, when the second end 830a of the first target element 826a abuts the first end 828b of the second target element 826b the first and second target elements 826a, 826b are centered with respect to each other.

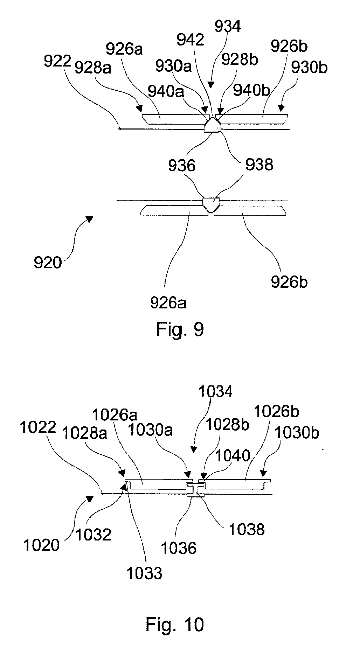

Fig. 9 shows a longitudinal cross-section of a further embodiment of a cylindrical target assembly, which may be combined with other embodiments disclosed herein. The cylindrical target assembly 920 includes a backing tube 922 and a plurality of target elements 926a, 926b. Typically, the target elements 926a, 926b have a defined length in the direction of the cylinder axis X, such that when all target elements 926a, 926b are mounted on the backing tube 922, the contact region 934, where a first end of a first target element and a second end of a second target element adjacent to the first target element abuts each other. According to some embodiments, which can be combined with other embodiments described herein, one or more recesses 936, in particular a circular groove, can be formed in the contact region 934 of the backing tube 922. A center element 938 is disposed in the recess 936. For example, the center element has two sloped surfaces 940a, 940b having a slope in opposite directions. The surfaces 940a, 940b have a common edge 942 disposed substantially parallel to the surface of the backing tube in circumferential direction, such that it forms a section of a circle, in particular concentrically arranged to the axis of the backing tube. In a typical embodiment, the sloped surfaces of the center element have an angle to an exterior surface of the backing tube of about 1 to about 89 degrees, in particular between about 20 and about 70 degrees.

In light of the above, the first and second target elements 926a, 926b can have a first end and a second end 928a, 928b, 930a, 930b that may be adapted to the center element 938. For example, the first end and/or the second end 928a, 928b, 930a, 930b may present a slope with respect to the inner surface of the first or second target element directed to the backing tube 922, which may be adapted to the surfaces 940a, 940b of the center element 938. The surfaces 940a, 940b of the center element may be substantial parallel to the slopes at the first end 928a, 928b or the second end 930a, 930b of the first or second target element 926a, 926b in the cross-sectional view of Fig. 9. Thus, due to thermal expansion or retraction, the respective target elements 926a, 926b remain concentrically arranged around the backing tube 922. In particular, the cone-shaped ends of the first or second target elements 926a, 926b allow a sliding movement on the surfaces 940a, 940b of the center element 938. Thus, the first and second target elements present a single cut-out at each end 928a, 928b, 930a, 930b. In another embodiment, the first and second target elements 926a, 926b may present at the first and second ends 928a, 928b, 930a, 930b more than one cut-out, for example 3 or 4 cut-outs, including the slope adapted to the center element 938. The number of cut-outs may be adapted to the number of center elements and disposed at an angular displacement corresponding of the angular displacement of the center elements on the backing tube.

Fig. 10 shows a longitudinal cross-section of a further embodiment of a cylindrical target assembly. The target assembly 1020 includes a backing tube 1022 having a groove 1036 in contact regions 1034 of target elements 1026a, 1026b. In the one or more recesses 1036, in particular a circular groove, a center element 1038 is disposed having a substantially double T-shape or a step shape. Typically, the center element 1038 has an outer surface, directed radially outwardly, that is substantially parallel to an outer surface of the backing tube 1022 directed to the target elements. The first and second target elements 1026a, 1026b have a first and a second end 1028a, 1028b, 1030a, 1030b which have a cut-out 1032, which is substantially rectangular in a longitudinal cross section, wherein a support surface 1033 is substantially parallel to the outer surface of the backing tube 1022. Thus, the support surfaces 1033 of the rectangular cut out 1032 of the first and second ends 1028a, 1028b, 1030a, 1030b are adapted to be arranged on the outer surface 1040 of the center element 1038, in the mounted state. Thus, similar to the embodiment shown in Fig. 9, the target elements are centered with respect to the backing tube 1022. Further, the cut outs 1032 are formed, such that a thermal expansion of the target elements 1026a, 1026b particularly in longitudinal or axial direction of the backing tube 1022, is allowed.

In a typical embodiment, which may be combined with other embodiments, disclosed herein, each target cylinder is supported at two spaced apart locations in longitudinal or axial direction, wherein at each location includes at least three or more protrusion receiving positions, and wherein protrusions are mounted on the exterior surface of the tube at each of the protrusion receiving positions for centering the target cylinders. For example the protrusions may be a center element, a spring, or a nose supporting and centering the target cylinder. In a typical embodiment, a nose provides a support surface which has substantial the same dimensions in circular direction and in longitudinal or axial direction of the backing tube. For example, a substantial punctual contact is provided. In an embodiment, for each target cylinder or tile, a spring and two bars or noses may be provided for supporting and centering the target cylinder, in particular with an angular displacement of 120 degrees in circumferential direction of the tube. Thus, a target cylinder is supported by three protrusions. In a further embodiment, more than 10 noses, springs, or center elements are provided on the exterior surface of the backing tube, in particular more than 30. Typically, the spaced apart locations may be at a contact region of two adjacent target cylinders.

As shown in Figs. 9 and 10, according to some embodiments described herein, center elements 938, 1038 can be used. As described above, the center elements can be configured to fit into a corresponding recess or corresponding recesses in the backing tube. In light of the size of the targets referred to herein, which can be, for example, 2000 mm or longer, the desired manufacturing precision of the target and the backing tube with respect to each other can be more easily obtained. That is, the recesses as well as the center element are compared to the backing tube relatively small. Thereby, the desired precision during manufacturing such that a non bonded target fits over the backing tube and is securely held during manufacturing can be provided by manufacturing the recesses in the backing tube and the center elements.

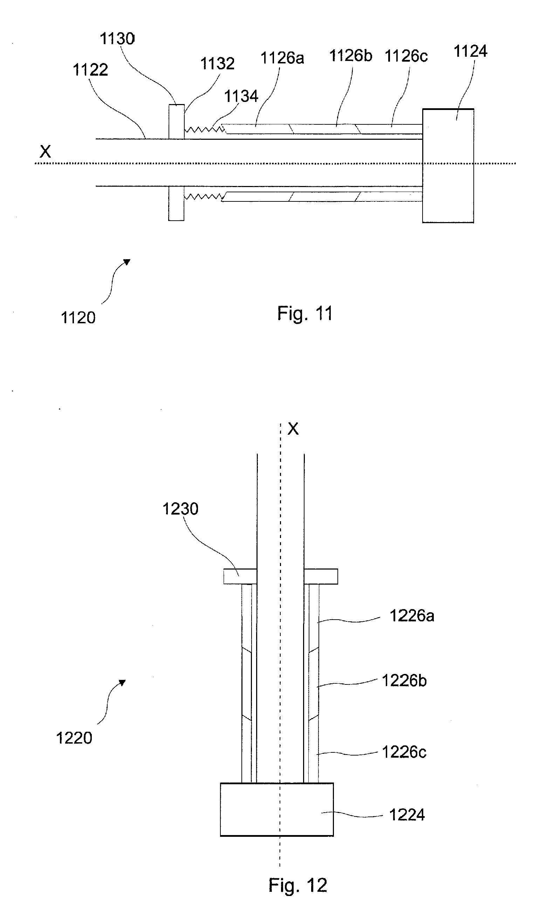

Fig. 11 shows a longitudinal cross-section of a further embodiment of a cylindrical target assembly, which may be combined with other embodiments disclosed herein. The cylindrical target assembly may be used with a horizontal or vertical arrangement of the rotating or cylindrical axis X of the backing tube. The cylindrical target element 1120 includes a backing tube 1122 having an abutting element or stop 1124 and a plurality of cylindrical target elements or segments 1126a, 1126b, 1126c that are disposed around the backing tube 1122. The target elements 1126a, 1126b, 1126c are disposed adjacent to each other and movably arranged in longitudinal direction of the backing tube 1122. Further, the cylindrical target assembly 1120 has a moveable member 1130 which may slide on the backing tube 1122 in the direction of the cylinder axis X. In a further embodiment, which may be combined with other embodiments, the movable member has a predetermined position on the backing tube 1122 when mounted thereon. Further, the moveable member 1130 may be fixed or seized with respect to the backing tube 1122 in a predetermined position to the backing tube 1122. According to typical embodiments, the movable member 1130 is ring shaped and surrounds the backing tube. In another embodiment, the cylindrical target assembly may comprise a plurality of movable members, for example two, three or more movable members disposed with an angular displacement around the circumference around the backing tube, each adapted to have a predetermined position on the backing tube 1122 when mounted thereon. The moveable member 1130 and the stop 1124 that is arranged at one end of the backing tube 1122 are arranged, such that all target elements 1126a, 1126b, 1126c are disposed between them. In an embodiment, which may be combined with other embodiments disclosed herein, the stop may be fixed at an arbitrary position on the backing tube. Then, the target elements are disposed between the stop and the movable member. The moveable member or, in case of a plurality of movable members, each movable member has a surface 1132 in direction of the target elements 1126a, 1126b, 1126c and the stop 1124. On the surface 1132 a biasing member 1134 is arranged having a biasing force in direction of the target elements 1126a, 1126b, 1126c and the stop 1124. The biasing member 1134 is arranged, such that the target elements 1126a, 1126b, 1126c are pressed against the stop 1124. Nevertheless, the biasing member 1134 allows a thermal expansion of the target elements 1126a, 1126b, 1126c during operation of the cylindrical target assembly in a vacuum chamber, and a reverse movement or shrinking when the temperature is lower in a cooling phase. Thus, no gaps between the target elements may occur during operation. For example the biasing member may be a leaf spring, a coil spring or any other resilient member that presses the target elements against the stop, and allows a thermal expansion of the target elements.

Fig. 12 shows a longitudinal cross section of a further embodiment of a cylindrical target assembly, which may be combined with other embodiments disclosed herein, in particular with any of the embodiments shown in Figs. 1 to 11. The cylindrical target assembly includes a backing tube 1222 on which a plurality of target elements 1226a, 1226b, 1226c, 1226d are disposed adjacent to each other, wherein at one end of the backing tube, a stop member 1224 is arranged. Fig. 12 refers to an embodiment, where the cylindrical target assembly is substantial vertically arranged. In other words, the rotating axis X of the backing tube 1222 is substantial vertically arranged. The stop 1224 is arranged substantially at the lower end of the backing tube. Further, the cylindrical target assembly 1220 includes a moveable member 1230 having a surface in direction of the target elements 1226a, 1226b, 1226c, 1226d. Due to the gravity forces, the moveable member 1230, which is in an embodiment substantially ring shaped and surrounding the backing tube, that is adapted to slide along the backing tube 1222 in the longitudinal direction of the backing tube, the moveable member 1230 pushes the target elements 1226a, 1226b, 1226c, 1226d in the direction of the stop 1224, such that no gaps occur between the target elements 1226a, 1226b, 1226c, 1226d, respectively. Further, the moveable member 1230 allows movement of the target elements due to thermal expansion and in the reverse direction during cooling. As it can be seen in Fig. 11 and 12, in a typical embodiment, the target cylinders have approximately the same shape. Nevertheless, as a further alternative or additional modification, a vertical arranged embodiment as shown in Fig. 12 can also include a biasing member according to any of the embodiments described with respect to Fig. 11.

Typically, the target elements or target segments or target rings enlarge radially and axially during operation in light of the high temperatures in the vacuum chambers. Typically, the temperature comes substantially from the target itself. On the other hand, the backing tube is cooled, for example by water flowing in the backing tube, and may have less thermal expansion.

Thus, the center ring may allow for axial and radial expansion of the segments and may allow a predetermined repositioning after the target elements cool down again.

In a typical embodiment, which may be combined with other embodiments, contact springs may be used that give way to tolerances during assembling of the target on the backing tube.

Typically, the backing tubes are very expensive and it is difficult to manufacture a backing tube with high accuracy. If a groove, for example the grooves shown in Figs. 9 and 10, is provided in the backing tube and a spring or a center element is provided within the grove, the groove and the ring or the spring or center element may be easier to manufacture with high accuracy. Typically, a backing tube with grooves and centering elements has little tolerances for centering and remaining tolerances are mainly determined by the tolerances of the target elements. In a typical embodiment, relative movement of a first target cylinder to a second target cylinder is avoided.

Further, in an embodiment, the springs may remain elastic even when used during several heating and cooling down periods. For example, stainless steel or copper-beryllium may be used as a material for the springs.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A target backing tube for a rotatable target comprising
a tube (122a, 122b, 222, 322, 422, 522, 722, 822, 922, 1022, 1122) adapted for one or more non-bonded target cylinders (126a, 126b, 226a, 226b, 226c, 226d, 326a, 326b, 426,526,626, 726a, 726b, 826a, 826b, 926a, 926b, 1026a, 1026b, 1126a, 1126b, 1126c, 1226a, 1226b, 1226c) to be disposed around the tube, the tube having an exterior surface adapted to face the at least one target cylinder and at least three or more protrusion receiving positions; and
protrusions (332, 332a, 332b, 322c, 432, 532, 632, 938, 1038) mounted on the exterior surface of the tube at each of the protrusion receiving positions for centering the target cylinders.

2. The target backing tube according to claim 1, wherein at least three protrusions per target cylinder are mounted on the exterior surface for supporting and centering the target cylinders when the target cylinders are arranged for a sputtering operation on the target backing tube.

3. The target backing tube according to claim 1 or 2, wherein the tube is adapted for at least two target cylinder to be disposed around the tube adjacent to each other, wherein each target cylinder has a first end (728a, 728b, 828a, 828b, 928a, 928b, 1028a, 1028b) and a second end (730a, 730b, 830a, 830b, 930a, 930b, 1030a, 1030b) in direction of the cylinder axis (X) opposite to the first end, wherein the first end of a first target cylinder is disposed adjacent to the second end of a second target cylinder, wherein a contact region is defined between the first end of the first target cylinder and the second end of the second target cylinder, respectively, when the target cylinders are arranged for a sputtering operation on the tube; wherein the at least three protrusion receiving positions are arranged on the exterior surface of the tube at the contact region (334, 334a, 334b, 334c, 934, 1034) , such that the protrusion is adapted to support and center the first end of the first target cylinder and the second end of the second target cylinder, wherein in particular the contact region is substantially circular.

4. The target backing tube according to claim 1 to 3, wherein
at least three protrusion receiving positions are arranged with an angular displacement of 120 degrees in circumferential direction of the tube, in particular at the contact region.

5. The target backing tube according to one of the claims 1 to 4, wherein the at least one protrusion are selected from the group consisting of: a nose; a resilient member, in particular a spring; a circular spring that is arranged substantially circumferential, a solid center element with a support surface and combinations thereof.

6. The target backing tube according to one of the claims 1 to 5, wherein
the tube comprises a recess (936, 1036) at least at one, in particular at each protrusion receiving position for a particular target cylinder when arranged for a sputtering operation on the tube, wherein the at least one protrusion is arranged in the recess, wherein in particular the recess is a substantial circular groove.

7. The target backing tube according to one of the claims 1 to 6, wherein
at least one protrusion, in particular each protrusion for a particular target cylinder when arranged for a sputtering operation on the tube, has at least one support surface (940a, 940b, 1040), wherein the at least one first support surfaces is substantial parallel to the exterior surface of the tube, or wherein
at least one protrusion, in particular each protrusion for a particular target cylinder when arranged for a sputtering operation on the tube, has two support surfaces (940a, 940b) that are oblique to the exterior surface of the tube, wherein the two support surfaces have a common edge (942), wherein the common edge is disposed substantially parallel to exterior surface of the tube in circumferential direction, wherein in particular the common edge forms a segment of a circular arc, wherein in particular the support surfaces have an angle with respect to the exterior surface of the tube of between 1 and 89 degrees, in particular between 1 and 45 degrees.

8. A target cylinder for a rotatable cylindrical target assembly of a sputtering system,
wherein
the target cylinder has a first end (728a, 728b, 828a, 828b, 928a, 928b, 1028a, 1028b) and a second end (730a, 730b, 830a, 830b, 930a, 930b, 1030a, 1030b) in direction of the cylinder axis (X) opposite to the first end, and an inner surface adapted to face a target backing tube onto which the target cylinder is adapted to be disposed and exterior surface, wherein at least one support surfaces (1033) are disposed in at least one cut-out (1032) at the first end and the second end at the inner surface, respectively, wherein in particular the target cylinder further comprises at least three support surfaces at the first end and the second end respectively, in particular arranged with an angular displacement of 120 degrees.

9. The target cylinder according to one of the claim 8, wherein
the support surfaces are inclined with respect to the inner surface of the target cylinder.

10. A cylindrical target assembly comprising
a target backing tube according to one of the claims 1 to 6 and
at least one first target cylinder and at least one second target cylinder disposed around the target backing tube, wherein each target cylinder has a first end and a second end in direction of the cylinder axis opposite to the first end, wherein the first end of a first target cylinder is disposed adjacent to the second end of a second target cylinder, wherein in particular the at least one first target cylinder and/or the at least one second target cylinder is a target cylinder according to one of the claims 8 to 9.

11. The cylindrical target assembly according to claim 10, wherein
the first end (728a, 728b) of the first target cylinder and the second end (730a, 730b) of the second target cylinder comprise a tongue and groove connection system, so that the tongue is arranged at the first end of the first target cylinder and the groove is disposed at the second end of the second target cylinder, and/or wherein
the first target cylinder (826a) and the second target cylinder (826b) have an inclined first end surface at their first end (828a, 828b) and an inclined second end surface at their second end (830a, 830b) with respect to an interior surface of the respective target cylinders (822), wherein the first end surface of the first target cylinder and the second end surface of the second target cylinder are substantially parallel, wherein in particular the inclination angle of the first and second end surfaces is between 1 and 89 degrees, in particular between 20 and 70 degrees, with respect to the interior surface of the target cylinder.

12. The cylindrical target assembly according to one of the claims 10 to 11 further comprising
a stop (230, 1124, 1224) disposed on the target backing tube, in particular at an end of the target backing tube in direction of the cylinder axis, wherein the stop is adapted to support the adjacent target cylinder in direction of the cylinder axis; and
at least one biasing device (1130, 1134, 1230) for pushing the target cylinders (1126a, 1126b, 1126c, 1226a, 1226b, 1226c) in direction of the stop in direction of the cylinder axis (X).

13. The cylindrical target assembly according to claim 12, wherein the cylinder axis of the target backing tube is arranged substantially vertical; wherein the at least one biasing device is adapted to slide in direction of the cylinder axis of the target backing tube, and is arranged such that the gravity of the biasing device pushes the target cylinders in direction of the stop.

14. The cylindrical target assembly according to one of the claims 12 to 13, wherein
the at least one biasing device comprises at least one resilient member (1134) for pushing the target cylinders in direction of the stop.

15. The cylindrical target assembly according to claim 14,
wherein the at least one biasing device (1130) is adapted to be fixed to the target backing tube.

## Amended claims

### Amended claims in accordance with Rule 137(2) EPC.

**1.** A target backing tube for a rotatable target comprising
a tube (122a, 122b, 222, 322, 422, 522, 722, 822, 922, 1022, 1122) adapted for one or more non-bonded target cylinders (126a, 126b, 226a, 226b, 226c, 226d, 326a, 326b, 426,526,626, 726a, 726b, 826a, 826b, 926a, 926b, 1026a, 1026b, 1126a, 1126b, 1126c, 1226a, 1226b, 1226c) to be disposed around the tube, the tube having an exterior surface adapted to face the at least one target cylinder and at least three or more protrusion receiving positions to support each target cylinder at two spaced apart locations in axial direction, wherein each location includes at least three protrusion receiving positions having an angular displacement; and
protrusions (332, 332a, 332b, 322c, 432, 532, 632, 938, 1038) mounted on the exterior surface of the tube at each of the protrusion receiving positions for centering the target cylinders.

**2.** The target backing tube according to claim 1, wherein at least three protrusions per target cylinder are mounted on the exterior surface for supporting and centering the target cylinders when the target cylinders are arranged for a sputtering operation on the target backing tube.

**3.** The target backing tube according to claim 1 or 2, wherein the tube is adapted for at least two target cylinder to be disposed around the tube adjacent to each other, wherein each target cylinder has a first end (728a, 728b, 828a, 828b, 928a, 928b, 1028a, 1028b) and a second end (730a, 730b, 830a, 830b, 930a, 930b, 1030a, 1030b) in direction of the cylinder axis (X) opposite to the first end, wherein the first end of a first target cylinder is disposed adjacent to the second end of a second target cylinder, wherein a contact region is defined between the first end of the first target cylinder and the second end of the second target cylinder, respectively, when the target cylinders are arranged for a sputtering operation on the tube; wherein the at least three protrusion receiving positions are arranged on the exterior surface of the tube at the contact region (334, 334a, 334b, 334c, 934, 1034), such that the protrusion is adapted to support and center the first end of the first target cylinder and the second end of the second target cylinder, wherein in particular the contact region is substantially circular.

**4.** The target backing tube according to claim 1 to 3, wherein
at least three protrusion receiving positions are arranged with an angular displacement of 120 degrees in circumferential direction of the tube, in particular at the contact region.

**5.** The target backing tube according to one of the claims 1 to 4, wherein the at least one protrusion is selected from the group consisting of: a nose; a resilient member, in particular a spring, a solid center element with a support surface and combinations thereof.

**6.** The target backing tube according to one of the claims 1 to 5, wherein
the tube comprises a recess (936, 1036) at each protrusion receiving position for a particular target cylinder when arranged for a sputtering operation on the tube, wherein each protrusion is arranged in a separate recess.

**7.** The target backing tube according to one of the claims 1 to 6, wherein
at least one protrusion, in particular each protrusion for a particular target cylinder when arranged for a sputtering operation on the tube, has at least one support surface (940a, 940b, 1040), wherein the at least one first support surfaces is substantial parallel to the exterior surface of the tube, or wherein
at least one protrusion, in particular each protrusion for a particular target cylinder when arranged for a sputtering operation on the tube, has two support surfaces (940a, 940b) that are oblique to the exterior surface of the tube, wherein the two support surfaces have a common edge (942), wherein the common edge is disposed substantially parallel to exterior surface of the tube in circumferential direction, wherein in particular the common edge forms a segment of a circular arc, wherein in particular the support surfaces have an angle with respect to the exterior surface of the tube of between 1 and 89 degrees, in particular between 1 and 45 degrees.

**8.** A target cylinder for a rotatable cylindrical target assembly of a sputtering system,
wherein
the target cylinder has a first end (728a, 728b, 828a, 828b, 928a, 928b, 1028a, 1028b) and a second end (730a, 730b, 830a, 830b, 930a, 930b, 1030a, 1030b) in direction of the cylinder axis (X) opposite to the first end, and an inner surface adapted to face a target backing tube onto which the target cylinder is adapted to be disposed and exterior surface, wherein at least one support surfaces (1033) are disposed in at least one cut-out (1032) at the first end and the second end at the inner surface, respectively, wherein in particular the target cylinder further comprises at least three support surfaces at the first end and the second end respectively, in particular arranged with an angular displacement of 120 degrees.

**9.** The target cylinder according to one of the claim 8, wherein
the support surfaces are inclined with respect to the inner surface of the target cylinder.

**10.** A cylindrical target assembly comprising
a target backing tube according to one of the claims 1 to 6 and
at least one first target cylinder and at least one second target cylinder disposed around the target backing tube, wherein each target cylinder has a first end and a second end in direction of the cylinder axis opposite to the first end, wherein the first end of a first target cylinder is disposed adjacent to the second end of a second target cylinder, wherein in particular the at least one first target cylinder and/or the at least one second target cylinder is a target cylinder according to one of the claims 8 to 9.

**11.** The cylindrical target assembly according to claim 10, wherein
the first end (728a, 728b) of the first target cylinder and the second end (730a, 730b) of the second target cylinder comprise a tongue and groove connection system, so that the tongue is arranged at the first end of the first target cylinder and the groove is disposed at the second end of the second target cylinder, and/or wherein
the first target cylinder (826a) and the second target cylinder (826b) have an inclined first end surface at their first end (828a, 828b) and an inclined second end surface at their second end (830a, 830b) with respect to an interior surface of the respective target cylinders (822), wherein the first end surface of the first target cylinder and the second end surface of the second target cylinder are substantially parallel, wherein in particular the inclination angle of the first and second end surfaces is between 1 and 89 degrees, in particular between 20 and 70 degrees, with respect to the interior surface of the target cylinder.

**12.** The cylindrical target assembly according to one of the claims 10 to 11 further comprising
a stop (230, 1124, 1224) disposed on the target backing tube, in particular at an end of the target backing tube in direction of the cylinder axis, wherein the stop is adapted to support the adjacent target cylinder in direction of the cylinder axis; and
at least one biasing device (1130, 1134, 1230) for pushing the target cylinders (1126a, 1126b, 1126c, 1226a, 1226b, 1226c) in direction of the stop in direction of the cylinder axis (X).

**13.** The cylindrical target assembly according to claim 12, wherein the cylinder axis of the target backing tube is arranged substantially vertical; wherein the at least one biasing device is adapted to slide in direction of the cylinder axis of the target backing tube, and is arranged such that the gravity of the biasing device pushes the target cylinders in direction of the stop.

**14.** The cylindrical target assembly according to one of the claims 12 to 13, wherein
the at least one biasing device comprises at least one resilient member (1134) for pushing the target cylinders in direction of the stop.

**15.** The cylindrical target assembly according to claim 14,
wherein the at least one biasing device (1130) is adapted to be fixed to the target backing tube.
